# EUROPÄISCHE PATENTSCHRIFT

(11) **EP 0 887 633 B1**
(45) Veröffentlichungstag und Bekanntmachung des Hinweises auf die Patenterteilung: **26.07.2006**
(21) Anmeldenummer: 98105982.7
(22) Anmeldetag: 01.04.1998
(51) Int. Cl.: G01K 7/01, G01K 3/00

(54) **Schaltungsanordnung zum Erfassen des Überschreitens einer kritischen Temperatur eines Bauelements**
Circuit arrangement for detecting critical temperature crossing of a component
Montage de circuit pour détecter le passage d'une température critique d'un composant

(30) Priorität: 26.06.1997 DE 19727229
(43) Veröffentlichungstag der Anmeldung: 30.12.1998
(73) Patentinhaber: Infineon Technologies AG, 81669 München (DE)
(72) Erfinder: Wachter, Franz, 9504 Villach (AT)
(74) Vertreter: Kottmann, Heinz Dieter

(56) Entgegenhaltungen:
- EP-A- 0 341 482
- EP-A- 0 561 461
- PATENT ABSTRACTS OF JAPAN vol. 013, no. 421 (E-822), 19. September 1989 -& JP 01 155714 A (ROHM CO LTD), 19. Juni 1989

## Beschreibung

Schaltungsanordnung zum Erfassen des Überschreitens einer kritischen Temperatur eines Bauelements.

Die Erfindung betrifft eine Schaltungsanordnung zum Erfassen des Überschreitens einer kritischen Temperatur eines Bauelementes unter Verwendung von mindestens einem Sense-Transistor, der eine temperaturabhängige Strom-Spannungs-Charakteristik aufweist und der mit dem Bauelement thermisch verbundenen ist, und mit einer dem Sense-Transistor in Reihe geschalteten Stromquelle.

Eine derartige Schaltungsanordnung ist beispielsweise aus EP 0 341 482 A1 bekannt.

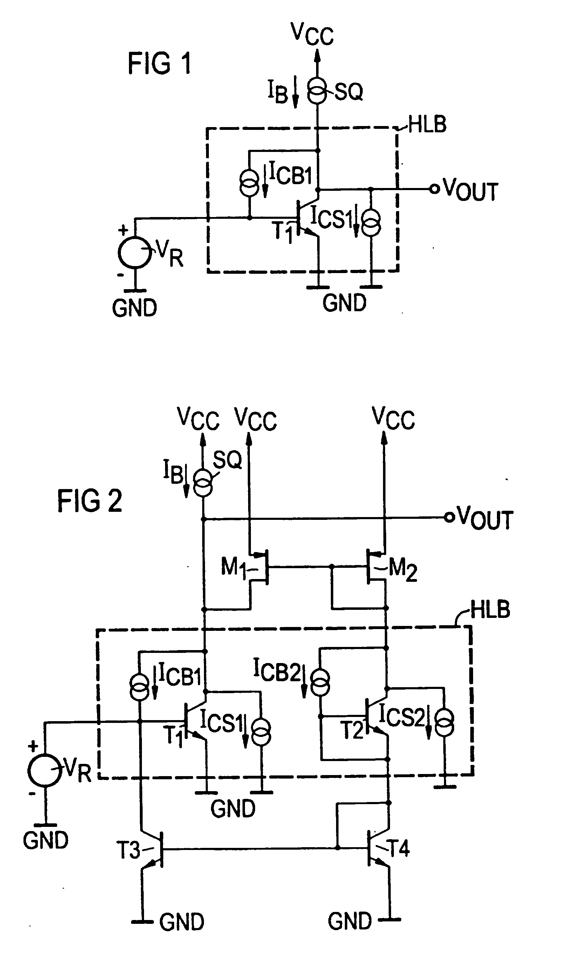

Anhand von Figur 1 der Zeichnung wird das Prinzip eines Temperatursensors der eingangs genannten Art näher erläutert. Die Schaltung in Figur 1 weist ein Bipolartransistor T₁ auf, dem eine Stromquelle SQ in Reihe geschaltet ist. Der Bipolartransistor T₁ ist mit dem auf Übertemperatur zu überwachenden Halbleiterbauelement, z. B. einem Leistungs-MOSFET oder einem Leistungs-IC, thermisch verbunden. Die Stromquelle SQ kann als MOS-Halbleiterbauelement, beispielsweise durch einen n-Kanal-Depletion-Transistor, realisiert sein. Die Reihenschaltung aus Stromquelle SQ und Bipolartransistor T₁ ist zwischen den Anschlüssen eines ersten und zweiten Versorgungspotentials V_{CC}, GND angeordnet. Der Basisanschluß des Transistors T₁ ist mit einer Referenzspannungsquelle VR verbunden.

Die Stromquelle SQ versorgt den Bipolartransistor T₁ mit einem Konstantstrom I_{B}. Gleichzeitig wird eine konstante Basisspannung über die Referenzspannungsquelle VR am Basisanschluß des Transistors T₁ eingeprägt. Bei niedrigen Temperaturen ist der Bipolartransistor T₁ gesperrt und sein Kollektorpotential V_{Out} entspricht dem Wert der Betriebsspannung. Übersteigt bei steigender Temperatur und konstanter Basisemitterspannung die Fähigkeit des Bipolartransistors Kollektorstrom zu ziehen die Fähigkeit der Stromquelle SQ Konstantstrom zu liefern, dann schaltet am Ausgang der Temperatursensoranordnung das Kollektorpotential auf·LOW. Durch die entsprechende Wahl der Referenzspannung V_{R} an der Basis kann die Abschalttemperatur geeignet gewählt werden.

Eine derartige Temperatursensoranordnung muß die Temperatur eines Halbleiterbauelementes verläßlich erfassen und bei einer Übertemperatur des Halbleiterbauelements ein Signal erzeugen, welches das Halbleiterbauelement abschaltet. Erfolgt dies nicht, kann es zur Zerstörung des Halbleiterbauelements kommen.

Wird ein pn-Übergang in Sperrichtung gepolt, hat die angelegte Sperrspannung zur Folge, daß Elektronlochpaare, die überall in der Diode durch thermische Generation entstehen, an den Rändern der Raumladungszone getrennt und die Minoritätsträger über die Raumladungszone abgesaugt werden. Die Rekombination nimmt gegenüber der thermischen Generation ab. Steigt die Temperatur, nimmt auch die Generation zu, mehr Minoritätsträger passieren die Raumladungszone und der Strom steigt exponentiell an.

Der parasitäre Sperrschichtleckstrom ist bei Raumtemperatur vernachlässigbar. Jedoch erreicht der parasitäre Leckstrom bei höheren Temperaturen, üblicherweise bei Temperaturen über 150°C, gefährlich hohe Werte. Beispielsweise beträgt der parasitäre Kollektorsubstratstrom I_{CS1} eines gebräuchlichen npn-Bipolartransistors bei 300°C bereits etwa 30 µA.

Die verläßliche Erfassung der Temperatur eines Halbleiterbauelementes ist jedoch nur eingeschränkt möglich. Insbesondere bei Temperaturen über 150°C werden parasitäre Sperrschichtleckströme in zunehmenden Maße wirksam. Diese parasitären Leckströme beeinträchtigen maßgeblich die Funktion des Temperatursensors bzw. können diesen sogar unwirksam machen. Insbesondere für sehr hohe Temperaturen kann dies sogar zur Zerstörung des Halbleiterbauelements führen.

Aufgabe der vorliegenden Erfindung ist es daher, eine Schaltungsanordnung zum Erfassen des Überschreiten seiner vorgegebenen Temperatur eines Halbleiterbauelements anzugeben, bei der die erwähnten parasitären Leckströme schaltungstechnisch auf einfache Weise kompensiert werden.

Erfindungsgemäß wird diese Aufgabe durch eine Schaltungsanordnung gemäß Anspruch 1 gelöst.

Vorteil der erfindungsgemäßen Schaltungsanordnung ist es, daß die parasitären Leckströme am Sense-Transistor vollständig kompensiert werden und somit die volle Funktionsfähigkeit des Temperatursensors im gesamten Temperaturbereich des Temperatursensors gewährleistet ist.

Ein weiterer wesentlicher Vorteil der vorliegenden Erfindung ist die schaltungstechnisch einfache Realisierung. Zwar lassen sich im Stand der Technik die parasitären Leckströme reduzieren, jedoch erfordert diese schaltungstechnische Reduzierung erheblichen Schaltungsaufwand. Zudem lassen sich die parasitären Leckströme im gesamten Temperaturbereich nie ganz eliminieren.

Das zu untersuchende Bauelement ist üblicherweise ein Halbleiterbauelement. Typischerweise handelt es sich hierbei bevorzugt um ein Leistungshalbleiterbauelement, beispielsweise ein DMOS-Transistor oder ein SPT-Transistor. Die Erfindung erweist sich jedoch auch vorteilhaft für Anwendungen bei anderen Bauelementen, die nicht notwendigerweise aus Halbleitermaterial bestehen.

Typischerweise ist der Sense-Transistor als npn-Bipolartransistor ausgebildet. Selbstverständlich läßt sich der Sense-Transistor auch als pnp-Bipolartransistor oder durch ein ähnliches Halbleiterbauelement realisieren.

Die Schaltungsanordnung zur Kompensation der parasitären Leckströme ist durch einen Meßtransistor und durch zwei Stromspiegelschaltung ausgebildet. Der Meßtransistor ist vorteilhafterweise in unmittelbarer Nähe zum Sense-Transistor angeordnet, so daß er derselben Umgebungstemperatur ausgesetzt ist. Der Meßtransistor mißt die parasitären Leckströme am Sense-Transistor. Über die beiden Stromspiegelschaltungen kann der parasitäre Kollektorbasisleckstrom sowie der parasitäre *Kollektorsubstratleckstrom* kompensiert werden. Es ist besonders vorteilhaft, wenn der Meßtransistor vom gleichen Leitungstyp und identisch zum Sense-Transistor aufgebaut ist.

Es ist jedoch auch denkbar, mehrere Sense-Transistoren sowie mehrere Stromspiegelschaltungen zur Kompensation der parasitären Leckströme in unmittelbarer Nähe zum Sense-Transistor anzuordnen. Auf diese Weise lassen sich Meßungenauigkeiten, die sich bei der Verwendung eines einzelnen Meßtransistors ergeben, mitteln und somit der Gesamtfehler verringern.

Zwischen dem Steueranschluß des Sense-Transistors kann ein Spannungsteiler vorgeschaltet werden, über den der Spannungsabgriff von der Referenzspannungsquelle erfolgt. Vorteilhafterweise ist der Widerstand als ein kallibrierbaren Spannungsteiler ausgebildet. Durch entsprechende Dimensionierung dieses Spannungsteilers Widerstands kann die Schalttemperatur und damit das Ansprechverhalten des Temperatursensoranordnung definiert eingestellt werden.

In einer Ausgestaltung der Erfindung ist es vorteilhaft, der Basisemitterstrecke des Sense-Transistors ein Kondensator parallel zu schalten. Durch diesen Kondensator lassen sich von der Versorgungsspannungsquelle stammende Störspannungen weitgehend unschädlich machen.

Vorteilhafterweise läßt sich die Stromquelle auch als schaltbares, feldeffektgesteuertes Halbleiterbauelement realisieren. Typischerweise ist hier meist ein MOSFET vorgesehen. Es ist jedoch auch eine andere Realisierung der Stromquelle denkbar.

In einer weiteren Ausgestaltung der Erfindung ist es vorteilhaft, zwischen den Kollektoremitteranschlüssen des Sense-Transistors eine Zenerdiode zur *Spannungsbegrenzung* vorzusehen. Statt der Zenerdiode sind jedoch auch andere Mittel zur *Spannungsbegrenzung* denkbar.

Insbesondere bei BICD-MOS-Anwendungen sind Temperatursensoren, die beispielsweise die Übertemperatur eines integrierten DMOS-Leistungstransistors erkennt und die zugehörige Treiberschaltung abschaltet, von sehr großer Bedeutung. Die Treiberschaltung beinhaltet eine Strombegrenzung, die bei etwa 2 A liegt. Da Kurzschlußfestigkeit bei 40 Volt Drain/Source-Spannung gefordert ist, wird es notwendig, den Temperatursensor an der potentiell heißesten Stelle des Halbleiterbauelements, d. h. in der Mitte des DMOS-Leistungstransistors, anzuordnen. Die Laufzeit der thermischen Welle vom heißesten Punkt des Temperatursensors würden ansonsten zur thermischen Zerstörung des Leistungstransistors noch vor der Übertemperaturerkennung durch den Temperatursensor führen.

Eine weitere Anforderung an den Temperatursensor ergibt sich im Nichtkurzschlußfall. Hier muß der Temperatursensor beispielsweise bei einer Einschaltzeit von mindestens 2 ms ohne Ansprechen des Temperatursensors im Nichtkurzschlußfall unter der Bedingung U_{DS} ≈ 18 V, I_{D} ≈ 2 A funktionsfähig sein. Verursacht durch die Verlustleistung bei einer angenommenen Transistorfläche von 0,8 mm² kann die Temperatur am Rand des Transistors *abhängig von der Starttemperatur* etwa 200°C betragen, während die Temperatur im Transistormittelpunkt nach der genannten Zeit bei etwa 300°C liegt. Die genannten hohen Temperaturen stellen hier zwar kein Zuverlässigkeitsproblem dar, da sie in der gesamten Lebensdauer der integrierten Schaltung höchstens 100 mal für maximal 2 ms vorkommen können. Elementar wichtig bei einer derartigen Temperaturmessung ist jedoch, daß diese definiert und zuerfolgt. Derartige Anforderung sind insbesondere für die Spezifikation eines Airbag-Sensors gefordert.

Nachfolgend wird die Erfindung anhand der in den Figuren der Zeichnung angegebenen Ausführungsbeispiele näher erläutert.

Es zeigt:
- Figur 1: das Prinzipschaltbild eines Temperatursensors nach dem Stand der Technik;
- Figur 2: das Prinzipschaltbild eines erfindungsgemäßen Temperatursensors, bei dem die parasitären Leckströme schaltungstechnisch vollständig kompensiert sind.
- Figur 3: ein weiteres, bevorzugtes Prinzipschaltbild eines erfindungsgemäßen, vollständig kompensierten Temperatursensors.

Figur 2 zeigt ein vollständig kompensierten erfindungsgemäßen Temperatursensor. Dabei sind gleiche oder funktionsgleiche Elemente wie in Figur 1 mit gleichen Bezugszeichen versehen.

Figur 2 zeigt einen Sense-Transistor T₁, der im Zentrum eines Halbleiterbauelements HLB, beispielsweise eines DMOS-Transistors, angeordnet ist. Der Sense-Transistor T₁ ist dabei mit dem Halbleiterbauelement HLB thermisch verbunden.

Emitterseitig ist der Sense-Transistor T₁ mit dem Anschluß eines ersten Bezugspotentials GND verbunden. Kollektorseitig ist der Sense-Transistor über die Stromquelle SQ mit dem Anschluß eines zweiten Bezugspotentials V_{CC} verbunden. Der Basisanschluß des Sense-Transistors T₁ ist über eine Referenzspannungsquelle V_{R} ebenfalls mit dem Anschluß des ersten Bezugspotentials GND verbunden. Am Kollektor des Meßtransistors T₁ ist das Ausgangssignal der Temperatursensoranordnung abgreifbar.

Im vorliegenden Fall ist der Sense-Transistor T₁ ein npn-Bipolartransistor, er kann jedoch auch durch einen pnp-Transistor ausgebildet sein. Das erste Versorgungspotential GND ist hier das Potential der Bezugsmasse. Die Stromquelle SQ kann in einer vorteilhaften Ausführung auch durch ein schaltbares feldeffektgesteuertes Halbleiterbauelement, beispielsweise durch ein n-Kanal-Depletion-MOSFET, realisiert sein.

Parallel zur Emitter/Kollektor-Laststrecke des Sense-Transistors T₁ ist ein Meßtransistor T₂ angeordnet. Die Basis/Emitter-Strecke des Meßtransistors T₂ ist hierbei kurzgeschlossen. Erfindungswesentlich ist dabei, daß der Meßtransistor T₂ in unmittelbarer Nähe zum Sense-Transistor T₁ angeordnet ist und ebenfalls mit dem Halbleiterbauelement HLB thermisch verbunden ist. Außerdem ist es erfindungswesentlich, daß der Meßtransistor T₂ vom selben Leitungstyp, im vorliegenden Beispiel handelt es sich um einen npn-Bipolartransistor, sowie identisch zum Sense-Transistor T₁ aufgebaut ist.

Zwischen den Basisanschlüssen des Sense-Transistors T₁ und des Meßtransistors T₂ und dem Anschluß des ersten Versorgungspotentials GND ist eine erste Stromspiegelschaltung geschaltet. Die erste Stromspiegelschaltung besteht hierbei aus zwei npn-Bipolartransistoren T₃, T₄. Die erste Stromspiegelschaltung kann jedoch auch durch andere Transistorentypen, beispielsweise MOSFETs, realisiert sein. Jedoch ist die Verwendung von Bipolartransistoren in dem vorliegenden Ausführungsbeispiel wegen deren günstigeren Spannungsverhältnisse vorzuziehen.

Zwischen den Kollektoranschlüssen des Sense-Transistors T₁ und des Meßtransistors T₂ und dem Anschluß des zweiten Versorgungspotentials V_{CC} ist eine zweite Stromspiegelschaltung angeordnet. Im vorliegenden Beispiel wird die zweite Stromspiegelschaltung durch zwei p-MOS-Sperrschichttransistoren M₁, M₂ realisiert. Es ist jedoch auch denkbar, die Transistoren M₁, M₂ der zweiten Stromspiegelschaltung ebenfalls bipolar zu realisieren.

Des weiteren sind in Figur 2 die parasitären Kollektor/Basis-Leckströme I_{CB1}, I_{CB2} sowie die parasitären Kollektorsubstratleckströme I_{CS1}, I_{CS2} am Sense-Transistor T₁ und am Meßtransistor T₂ eingezeichnet.

Nachfolgend wird die Funktionsweise der erfindungsgemäßen Temperatursensoranordnung näher erläutert.

Der Meßtransistor T₂ zur Bestimmung der parasitären Ströme ist benachbart zum Sense-Transistor T₁ in der Mitte des Halbleiterbauelements HLB angeordnet. Die beiden Transistoren T₁, T₂ sind vom gleichen Leitungstyp und in der Weise symmetrisch angeordnet, daß sie möglichst dieselbe Umgebungstemperatur aufweisen. Daher sind ihre Leckströme I_{CB1}, I_{CB2} bzw. I_{CS1}, I_{CS2} nahezu identisch. Dieser Umstand ist auch dann gültig, wenn die entsprechende Sperrspannungen U_{CB} bzw. U_{CS} an den beiden Transistoren unterschiedlich sind, da die Spannungsabhängigkeit des Sperrstromes weitgehendst vernachlässigt werden kann.

Der zweite Stromspiegel M₁, M₂ spiegelt den Leckstrom I_{CS2} vom Meßtransistor T₂ zum Kollektor des Sense-Transistors T₁. Damit wird der Kollektorsubstratsperrstrom I_{CS1} des Sense-Transistors T₁ kompensiert. Der Kollektorbasisleckstrom I_{CB1} wird vom bipolaren Stromspiegel T₃, T₄ und dem primär eingeprägten Leckstrom I_{CB2} in der Art unwirksam gemacht, daß die Strombilanz der Leckströme I_{CB1} - I_{CB2} an der Basis des Sense-Transistors T₁ ebenfalls gleich 0 ist.

Somit wird der Sense-Transistor T₁ über den gesamten Temperaturbereich mit demselben Stromangebot, welcher von der Stromquelle SQ eingeprägt wird, am Kollektor versehen. Die eingeprägte Basis/Emitter-Spannung bleibt somit unabhängig von der Temperatur konstant.

Über eine entsprechende Wahl der Basis/Emitter-Spannung und des eingeprägten Stroms der Stromquelle SQ läßt sich der Temperaturabschaltwert gezielt dimensionieren.

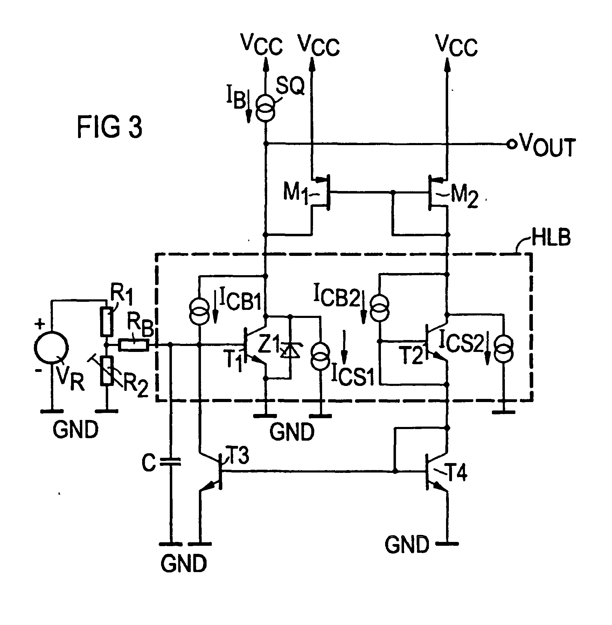

Figur 3 zeigt eine vorteilhafte Weiterbildung der erfindungsgemäßen Temperatursensoranordnung mit vollständig kompensierten Leckströmen entsprechend Figur 2. Gleiche bzw. funktionsgleiche Elemente sind mit gleichen Bezugszeichen entsprechend Figur 2 versehen.

In Figur 3 ist zusätzlich zwischen dem Kollektor/Emitter-Anschluß eine Zenerdiode Z₁ zur Spannungsbegrenzung vorgesehen. Des weiteren ist zwischen dem Basis/Emitter-Anschluß des Meßtransistors T₁ ein Kondensator C parallel geschaltet. Der Kondensator C macht die von der Versorgungsspannungsquelle stammende Störspannung weitgehend unschädlich.

Der Referenzspannungsquelle V_{R} ist ein Spannungsteiler bestehend aus einem ersten Widerstand R₁ und einem zweiten Widerstand R₂ parallel geschaltet. Am Fußpunkt zwischen den beiden Widerständen R₁, R₂ und dem Basisanschluß des Sense-Transistors T₁ ist ein Bahnwiderstand R_{B} geschaltet. Über den Spannungsteiler R₁, R₂ wird die Referenzspannung heruntergeteilt. Der Spannungsabgriff erfolgt dann über den Bahnwiderstand R_{B}. Vorteilhafterweise ist einer der beiden Widerstände R₁, R₂, im vorliegenden Fall der zweite Widerstand R₂, einstellbar. Auf diese Weise läßt sich eine definierte Spannung an der Referenzspannungsquelle V_{R} abgreifen. Das Ansprechverhalten des Temperatursensors ist so über den drehbaren Spannungsteiler R₁, R₂ am Eingang, der die Referenzspannung V_{R} auf den erforderlichen Wert reduziert, leicht zu ändern.

Durch diese erfindungsgemäße Schaltungsanordnung ist es auf einfache Weise möglich, die parasitären, temperaturabhängigen Leckströme zu kompensieren. Die Funktion des Temperatursensors wird durch diese Maßnahme über den gesamten Temperaturbereich gewährleistet.

## Patentansprüche

1. Schaltungsanordnung zum Erfassen des Überschreitens einer kritischen Temperatur eines Bauelements (HLB) unter Verwendung von mindestens einem Sense-Transistor (T₁), der eine temperaturabhängige Strom-Spannungs-Charakteristik aufweist und der mit dem Bauelement (HLB) thermisch verbunden ist, und mit einer dem Sense-Transistor (T₁) in Reihe geschalteten Stromquelle (S_{Q}),
**dadurch gekennzeichnet ,**
**dass** eine Schaltungseinrichtung zur Kompensation der parasitären Leckströme (I_{CB1}, I_{CS1}) am Sense-Transistor (T₁) vorgesehen ist und die nachfolgenden Merkmale aufweist:
- mindestens einen Messtransistor (T₂), der mit dem Halbleiterbauelement thermisch verbunden ist und der symmetrisch zum Sense-Transistor (T₁) angeordnet ist, wobei die Messtransistoren (T₂) und Sense-Transistoren (T₁) baugleich sind,
- eine erste Stromspiegelschaltung (T₃, T₄), die zwischen den Basisanschlüssen der Sense- und Messtransistoren (T₁, T₂) und dem Anschluss eines ersten Versorgungspotentials (GND) angeordnet ist, und
- eine zweite Stromspiegelschaltung (M₁, M₂), die zwischen den Kollektoranschlüssen der Sense- und Messtransistoren (T₁, T₂) und dem Anschluss eines zweiten Versorgungspotentials (Vcc) angeordnet ist.

2. Schaltungsanordnung nach Anspruch 1,
**dadurch gekennzeichnet ,**
**dass** das Bauelement (HLB) ein Halbleiterbauelement ist.

3. Schaltungsanordnung nach einem der Ansprüche 1 bis 2,
**dadurch gekennzeichnet ,**
**dass** der Sense-Transistor (T₁) ein Bipolartransistor ist.

4. Schaltungsanordnung nach einem der Ansprüche 1 bis 3,
**dadurch gekennzeichnet ,**
**dass** der Basis-Emitter-Strecke des Sense-Transistors (T₁) ein Spannungsteiler (R₁, R₂) parallel geschaltet ist.

5. Schaltungsanordnung nach Anspruch 4,
**dadurch gekennzeichnet ,**
**dass** der Spannungsteiler (R₁, R₂) kalibrierbar ist.

6. Schaltungsanordnung nach einem der Ansprüche 1 bis 5,
**dadurch gekennzeichnet ,**
**dass** der Basis-Emitter-Strecke des Sense-Transistors (T₁) ein Kondensator (C) parallel geschaltet ist.

7. Schaltungsanordnung nach einem der Ansprüche 1 bis 6,
**dadurch gekennzeichnet ,**
**dass** die Stromquelle (S_{Q}) ein feldeffektgesteuertes Halbleiterbauelement ist.

8. Schaltungsanordnung nach einem der Ansprüche 1 bis 7,
**dadurch gekennzeichnet ,**
**dass** der Kollektor-Emitter-Strecke des Sense-Transistors (T₁) eine Zenerdiode (Z₁) parallel geschaltet ist.

## Claims

1. Circuit arrangement for registering that a critical temperature of a component (HLB) has been exceeded, using at least one sense transistor (T₁) which has a temperature-dependent current/voltage characteristic and is thermally connected to the component (HLB), and having a current source (S_{Q}) connected in series with the sense transistor (T₁), **characterized in that** a circuit device for compensating for parasitic leakage currents (I_{CB1}, I_{cs1}) at the sense transistor is provided (T₁) and has the following features:
- at least one measurement transistor (T₂) which is thermally connected to the semiconductor component and is arranged symmetrically with respect to the sense transistor (T₁), the measurement transistors (T₂) and sense transistors (T₁) being of identical construction,
- a first current mirror circuit (T₃, T₄) which is arranged between the base connections of the sense and measurement transistors (T₁, T₂) and the connection of a first supply potential (GND),
- a second current mirror circuit (M₁, M₂) which is arranged between the collector connections of the sense and measurement transistors (T₁, T₂) and the connection of a second supply potential (V_{cc}).

2. Circuit arrangement according to Claim 1, **characterized in that** the component (HLB) is a semiconductor component.

3. Circuit arrangement according to one of Claims 1 to 2, **characterized in that** the sense transistor (T₁) is a bipolar transistor.

4. Circuit arrangement according to one of Claims 1 to 3, **characterized in that** a voltage divider (R₁, R₂) is connected in parallel with the base-emitter junction of the sense transistor (T₁).

5. Circuit arrangement according to Claim 4, **characterized in that** the voltage divider (R₁, R₂) can be calibrated.

6. Circuit arrangement according to one of Claims 1 to 5, **characterized in that** a capacitor (C) is connected in parallel with the base-emitter junction of the sense transistor (T₁).

7. Circuit arrangement according to one of Claims 1 to 6, **characterized in that** the current source (SQ) is a field-effect controlled semiconductor component.

8. Circuit arrangement according to one of Claims 1 to 7, **characterized in that** a zener diode (Z₁) is connected in parallel with the collector-emitter path of the sense transistor (T₁).

## Revendications

1. Montage pour détecter qu'une température critique d'un composant (HLB) est dépassée, en utilisant au moins un transistor sense (T₁) qui a une caractéristique courant-tension en fonction de la température et qui est relié thermiquement au composant (HLB), et comprenant une source (SQ) de courant montée en série avec le transistor sense (T₁),
**caractérisé**
**en ce qu'**il est prévu un dispositif de circuit pour la compensation des courants de fuite (I_{CB1}, I_{CS1}) parasites sur le transistor sense (T₁) et qui a les caractéristiques suivantes :
- au moins un transistor (T₂) de mesure, qui est relié thermiquement au composant à semi-conducteurs et qui est disposé symétriquement du transistor sense (T₁), les transistors (T₂) de mesure et les transistors sense (T₁) étant d'une constitution identique ;
- un premier circuit (T₃, T₄) miroir de courant, qui est monté entre les bornes de base des transistors sense (T₁) et des transistors (T₂) de mesure et la borne d'un premier potentiel (GND) d'alimentation ; et
- un deuxième circuit (M₁, M₂) miroir de courant, qui est monté entre les bornes de collecteur des transistors sense (T₁) et des transistors (T₂) de mesure et la borne d'un deuxième potentiel (V_{cc}) d'alimentation.

2. Montage suivant la revendication 1,
**caractérisé**
**en ce que** le composant (HLB) est un composant à semi-conducteurs.

3. Montage suivant l'une des revendications 1 à 2,
**caractérisé**
**en ce que** le transistor sense (T₁) est un transistor bipolaire.

4. Montage suivant l'une des revendications 1 à 3,
**caractérisé**
**en ce qu'**un diviseur (R₁, R₂) de tension est monté en parallèle à la section base-émetteur du transistor sense (T₁).

5. Montage suivant la revendication 4,
**caractérisé**
**en ce que** le diviseur (R₁, R₂) de tension peut être étalonné.

6. Montage suivant l'une des revendications 1 à 5,
**caractérisé**
**en ce qu'**un condensateur (C) est monté en parallèle à la section base-émetteur du transistor sense (T₁).

7. Montage suivant l'une des revendications 1 à 6,
**caractérisé**
**en ce que** la source (SQ) de courant est un composant à semi-conducteurs commandé par effet de champ.

8. Montage suivant l'une des revendications 1 à 7,
**caractérisé**
**en ce qu'**une diode (Z₁) Zener est montée en parallèle à la section collecteur-émetteur du transistor sense (T₁).
